(19) **Europäisches Patentamt**

**European Patent Office**

**Office européen des brevets**

(11) **EP 0 642 030 B1**

(12) **FASCICULE DE BREVET EUROPEEN**

(45) Date de publication et mention
de la délivrance du brevet:
**08.11.2000 Bulletin 2000/45**

(51) Int. Cl.⁷: **G01R 33/06**, G01R 33/00

(21) Numéro de dépôt: **94401932.2**

(22) Date de dépôt: **31.08.1994**

(54) **Guide de flux magnétique à languettes et capteur magnétorésistif comportant ce guide**

Flussleiter mit Zungen und magnetischer Sensor mit einem solchen Flussleiter

Tongued magnetic flux guide and magnetic sensor, equipped with such a guide

(84) Etats contractants désignés:
**DE GB IT**

(30) Priorité: **02.09.1993 FR 9310459**

(43) Date de publication de la demande:
**08.03.1995 Bulletin 1995/10**

(73) Titulaire:
**COMMISSARIAT A L'ENERGIE ATOMIQUE
75015 Paris Cédex 15 (FR)**

(72) Inventeurs:
• **Mouchot, Jean
F-38000 Grenoble (FR)**
• **Fedeli, Jean-Marc
F-38140 Beaucroissant (FR)**

(74) Mandataire:
**Dubois-Chabert, Guy et al
BREVATOME
3, rue du Docteur Lanceraux
75008 Paris (FR)**

(56) Documents cités:
**EP-A- 0 534 791          WO-A-92/01945
GB-A- 2 169 434**

**Description**

La présente invention a pour objet un guide de flux magnétique et un capteur à effet magnétorésistif comprenant ce guide de flux comportant deux parties longitudinalement séparées par un entrefer, et en outre un barreau magnétorésistif disposé en regard de l'entrefer. Ce capteur est particulièrement destiné à la réalisation de têtes de lecture et/ou d'écriture d'informations enregistrées sous forme magnétique sur un support quelconque tel que disque dur, bande, disquette, ticket, carte, etc.

Ce capteur peut aussi servir pour la détection et la localisation de champs magnétiques faibles tels que le champ magnétique terrestre et la fuite de faibles champs magnétiques, associée par exemple à la présence de fissures dans des systèmes métalliques.

Les composants magnétorésistifs se présentent généralement sous la forme d'un barreau magnétorésistif de petite taille, dont les extrémités sont reliées à des amenées de courant destinées à faire circuler un courant dans le barreau. En présence d'un champ magnétique extérieur, l'aimantation M du barreau résistif s'oriente différemment ayant pour effet de modifier la résistivité du matériau. Une variation de la tension est alors observée aux bornes du barreau et la mesure de cette variation de tension est représentative de la valeur du champ magnétique extérieur. Elle peut aussi être représentative de sa direction.

Ainsi, en mesurant la résistance du barreau on peut mesurer un champ magnétique et réciproquement mesurer une résistance électrique en mesurant un champ magnétique.

Les capteurs magnétiques les plus récents utilisent des matériaux magnétorésistifs, déposés sous forme de film mince sur un substrat adapté. Ces films sont gravés selon les procédés de photolithographie afin de leur conférer la forme d'un barreau.

On définit le champ magnétique à saturation $H_s$ comme étant le champ magnétique appliqué au composant magnétorésistif au-dessus duquel la résistivité électrique intrinsèque $\rho$ du composant ne varie pratiquement plus.

On définit le rapport :

$$\frac{\Delta\rho}{\rho} = \frac{[\rho(H=0) - \rho(H=Hs)]}{\rho(H=0)}$$

où H représente la valeur du champ magnétique externe à mesurer : $\rho(H=0)$ est la résistivité du composant magnétorésistif en champ nul et $\rho(H=Hs)$ sa résistivité lorsque le composant est en présence d'un champ magnétique égal au champ à saturation.

En outre, $\Delta\rho/\rho = \Delta R/R$ , avec R représentant la résistance du composant magnétorésistif.

La sensibilité $\alpha$ de la structure magnétorésistive et donc celle d'un capteur à effet magnétorésistif sont définies par la variation de la magnétorésistance $\Delta R/R$, obtenue par application d'un champ magnétique externe unitaire ; elle satisfait à la relation :

$$\alpha = (\partial(\Delta R/R)/\partial H)_{H<Hs}.$$

La forme d'un composant magnétorésistif ou plutôt ses dimensions influent sur l'orientation de son aimantation. Ainsi, dans le cas d'une couche mince magnétique, l'aimantation a tendance à s'aligner dans le plan de la couche. De plus, dans le cas d'un barreau de grande longueur, l'aimantation est généralement orientée selon cette longueur. Cet effet traduit une recherche du minimum d'énergie magnétique.

Pour une direction d'aimantation donnée, il apparaît, dans le matériau, un champ magnétique appelé champ démagnétisant $H_d$ ou champ d'anisotropie de forme orienté dans la direction contraire à celle de l'aimantation. L'intensité du champ démagnétisant est fonction de la géométrie du matériau considéré et de la direction prise par l'aimantation en son sein.

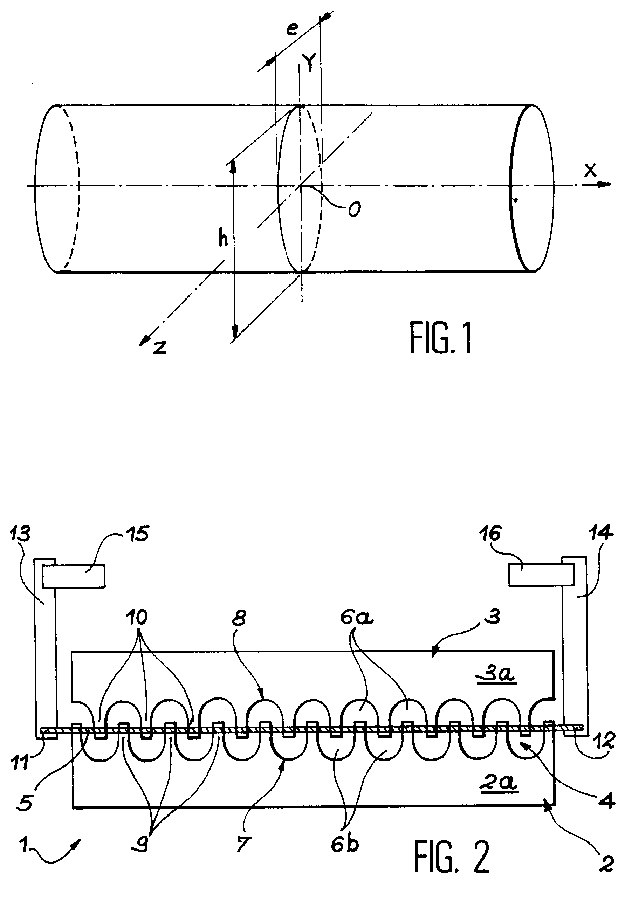

Sur la figure 1, on a représenté schématiquement un barreau magnétique de section elliptique, afin d'illustrer les composantes de ce champ démagnétisant.

On note les valeurs des coefficients de champ démagnétisant $N_X$, $N_Y$ et $N_Z$ respectivement selon les directions X, Y et Z d'un repère orthonormé OXYZ. Lorsque l'aimantation M est parallèle à la direction X, le champ démagnétisant vérifie la relation $H_d = N_X.M$.

Pour un barreau magnétorésistif de section elliptique supposé infiniment long aligné selon la direction X et présentant une épaisseur $\underline{e}$ selon la direction Z et une hauteur h selon la direction Y, on vérifie les relations : $N_X = 0$, $N_Y = e/(h+e)$, $N_Z = h/(h+e)$ .

Dans le cas d'un barreau de section rectangulaire d'épaisseur e faible devant sa hauteur h, elle même faible devant sa longueur L, une première approximation consiste à considérer que : $N_X = 0$, $N_Y = e/h$ , $N_Z = 1$.

Ainsi, un champ magnétique extérieur H appliqué selon la direction Y sera diminué, au sein du composant magnétorésistif par le champ démagnétisant $H_d$ approximativement égale dans le dernier cas particulier à (e/H)M, alors que ce même champ magnétique extérieur appliqué selon la direction X ne sera pas diminué.

Notons que cette approche n'est plus rigoureuse dès que la longueur du composant est comparable à sa hauteur (ou largeur).

Ainsi, le champ démagnétisant est susceptible d'augmenter la valeur du champ à saturation Hs et donc de diminuer la sensibilité du capteur.

Jusqu'à présent, les matériaux magnétorésistifs qui servaient à la réalisation des capteurs magnétiques étaient des matériaux monolithiques du type ferromagnétique. Il s'agissait principalement des composés à base de fer et de nickel ($Fe_{19}Ni_{81}$, $Fe_{20}Ni_{80}$) et des composés à base de fer, de nickel et de cobalt ($Fe_{15}Ni_{65}Co_{20}$, $Fe_5Ni_{80}Co_{15}$, ...).

Actuellement, de nouveaux matériaux magnétorésistifs sont disponibles. Il s'agit de structures magnétiques multicouches métalliques (SMMM) constituées d'un empilement de couches magnétiques séparées par des couches métalliques non magnétiques d'une épaisseur telle que s'établisse un couplage antiferromagnétique entre les couches magnétiques.

Les structures magnétiques multicouches métalliques étudiées sont variées. Elles sont constituées de métaux choisis parmi le cobalt, le fer, le nickel, les alliages de fer et de nickel, le cuivre, le chrome, l'argent, l'or, le molybdène, le ruthénium et le manganèse, comme décrit dans le document (1) de H. Yamamoto et T. Shinjo (IEEE Translation Journal on Magnetics in Japan, vol.7, n°9. Septembre 1992, "Magnetoresistance of multilayers", p. 674-684).

Les SMMM présentant à ce jour le plus grand nombre de propriétés requises (large effet magnétorésistif, faible champ à saturation, faible coercitivité, bonne tenue au recuit) sont constituées de couches de FeNi séparées par des couches de cuivre comme décrit dans le document (2) de S.S.P. Parkin ("Oscillations in giant magnetoresistance and antiferromagnetic coupling in $[Ni_{81}Fe_{19}/Cu]_N$ multilayers", Appl. Phys. Lett. 60, n°4, Janvier 1992, p. 512-514) et le document (3) de R. Nakatani et al. (IEEE Transactions on Magnetics, vol.28, n°5, Septembre 1992, "Giant magnetoresistance in Ni-Fe/Cu multilayers formed by ion beam sputtering", p. 2668-2670) ou encore de couches minces de FeNi séparées par des couches d'argent, comme décrit dans le document (4) de B. Rodmacq et al., (Journal of Magnetism and Magnetic materials 118, 1993, p.L11-L16, "Magnetoresistive properties and thermal stability of Ni-Fe/Ag multilayers").

Ces nouveaux matériaux ont la propriété d'être fortement magnétorésistifs, c'est-à-dire d'avoir un rapport $\Delta\rho/\rho$ allant de 10 à 20%, et de présenter des champs magnétiques à saturation faibles, c'est-à-dire inférieurs à 40kA/m.

Dans les SMMM l'effet magnétorésistif correspond à la rotation des aimantations de chacune des couches magnétiques qui s'accompagnent d'une diminution de la résistance électrique lors de l'application d'un champ magnétique extérieur. Le champ à saturation Hs correspond dans ce cas au champ magnétique extérieur qu'il faut appliquer pour orienter, dans une même direction et un même sens, l'aimantation de chacune des différentes couches magnétiques.

Dans le cas des matériaux ferromagnétiques utilisés dans les magnétorésistances monolithiques, la résistance varie avec l'angle que forme la direction de la densité de courant qui traverse le composant et la direction d'aimantation dans ce matériau. La résistance est la plus faible lorsque cet angle est égal à $\frac{\pi}{2}$. On n'a donc pas intérêt dans ce cas à appliquer le champ magnétique externe à mesurer dans n'importe quelle direction, mais perpendiculairement à la longueur du composant magnétorésistif.

En revanche, parallèlement à la longueur du barreau, il n'y a pas d'effet magnétorésistif au sein des matériaux ferromagnétiques monolithiques.

Dans les nouvelles structures SMMM, la variation de la résistivité, et donc de la résistance, est pratiquement indépendante de l'angle formé entre la direction du champ présent au sein du composant magnétorésistif et de la direction du courant qui traverse le composant magnétorésistif.

Mais ce champ est égal à la différence entre le champ démagnétisant $H_d$ et le champ magnétique externe à mesurer H du fait que la forme et la dimension de ces structures SMMM sont telles que, d'un point de vue magnétique, ces structures SMMM sont généralement anisotropes. Les coefficients de champ démagnétisant n'étant pas identiques dans toutes les directions du composant, sa sensibilité varie avec la direction du champ magnétique à mesurer, dès lors que celui-ci présente une anisotropie de forme.

Le but de l'invention est de réaliser un capteur de très grande sensibilité disposant d'un guide de flux et permettant de s'affranchir des effets liés à l'anisotropie de forme (parallélépipédique) la structure magnétorésistive étant employée en mode transverse.

Selon l'invention, la première et la seconde parties du guide sont pourvues en leurs bords jouxtant l'entrefer respectivement d'une première et d'une seconde séries de languettes séparées par des espacements, les languettes de la première partie s'étendant dans les espacements entre les languettes de la seconde partie et, réciproquement. Pour l'application au capteur, le barreau magnétorésistif présente de l'effet magnétorésistif quand le champ magnétique externe à mesurer a la même direction que la longueur du barreau.

Les lignes du champ appliqué qui initialement sont canalisées par des parties massives du guide de flux voient leur direction modifiée dans la région de l'entrefer par les languettes.

La direction est modifiée de manière à orienter les lignes selon la direction de facile aimantation du barreau magnétorésistif. Cette direction, comme cela a été précédemment explicité, se situe dans le sens de la longueur du barreau dans laquelle le champ démagnétisant est particulièrement faible.

Le champ à saturation Hs étant peu affecté par le champ démagnétisant, équivaut quasiment au champ à saturation du matériau "massif".

Afin d'augmenter l'efficacité de la déviation des lignes du champ appliqué, l'entrefer est avantageusement de taille plus réduite entre les parties latérales des languettes qu'entre les parties frontales et le bord de la partie du guide respectivement en regard des languettes.

Le barreau placé en regard de l'entrefer se superpose, avantageusement, partiellement au moins, aux languettes et sa longueur est choisie au moins égale à la longueur du guide de flux.

Le barreau intervient lui-même dans la déviation des lignes de champ dans la mesure où, magnétiquement perméable, il attire à lui les lignes de champ.

En jouant sur la forme des languettes, sur leurs dimensions ainsi que sur les dimensions de l'entrefer, il est possible d'adapter parfaitement la déviation des lignes de champ à la forme, nature et/ou arrangement du barreau magnétorésistif choisi. Effectivement, selon la perméabilité magnétique plus ou moins grande du barreau, ainsi que la distance (dans une direction perpendiculaire à la surface) le séparant du guide, les lignes de champ seront plus ou moins facilement attirées par le barreau.

Lorsque ce dernier n'attire pas suffisamment les lignes de champ dans la direction de sa longueur, on ajuste la forme des languettes de manière à réaliser un guide déviant davantage les lignes de champ.

Ainsi, plusieurs formes de languettes peuvent convenir. Des formes relativement simples telles que la forme rectangulaire ou trapézoïdale selon un plan parallèle à la surface du barreau sont particulièrement adaptées.

Par ailleurs, les bords des guides en regard du barreau présentent une courbure entre deux de leurs languettes.

La distance Φ séparant la partie frontale des languettes du bord de la partie du guide faisant respectivement face aux languettes peut, par exemple, varier de façon continue avec une valeur maximale dans une direction parallèle aux languettes.

Selon une autre caractéristique de l'invention, le barreau magnétorésistif et/ou le guide de flux sont réalisés en couche mince.

Avantageusement, le barreau est choisi du type structure magnétique multicouche métallique.

Ainsi, le barreau magnétorésistif est formé d'un empilement de couches en matériau magnétique séparées par des couches de matériau non magnétique. Les matériaux magnétiques peuvent être l'un de ceux cités précédemment. De préférence, on utilise un matériau magnétique en alliage de fer, nickel et cobalt (FeNiCo) ou en alliage de fer et de nickel (FeNi).

En outre, le matériau non magnétique est avantageusement du cuivre ou de l'argent.

Le barreau comprendra par exemple un empilement de 20 bicouches d'une épaisseur totale de 0,05 μm environ.

Le guide de flux est réalisé en un matériau magnétique doux choisi par exemple parmi des alliages à base de fer et de nickel, ou de fer, d'aluminium et de silicium.

De manière particulièrement intéressante, le guide présente également une structure multicouche métallique, ce qui lui confère pour certaines de ces structures une forte perméabilité magnétique en champs faibles, une faible hystérésis magnétique et une faible anisotropie magnétique.

Les guides de flux et le barreau sont réalisés sur un substrat non conducteur et non magnétique.

On entend par substrat non-conducteur, un substrat isolant ou semi-conducteur.

Parmi les substrats généralement utilisés, on peut citer le verre amorphe et le silicium ou encore des matières organiques telles qu'un polyimide vendu sous la marque déposée Kapton.

De plus, une couche en matériau magnétiquement et électriquement isolant, par exemple en silice, nitrure de silicium, est préalablement prévue pour séparer le guide des amenées de courant et aussi du barreau.

Pour améliorer la qualité cristalline de la ou des structures multicouches et par conséquent notamment l'effet magnétorésistif recherché, une fine couche d'accrochage de fer ou de cuivre peut être déposée par exemple préalablement sur le substrat.

Selon une variante de réalisation, on peut très bien former d'abord le guide de flux par dépôt du matériau doux ou de la structure multicouche puis gravure selon la forme voulue, directement sur le substrat, déposer la couche magnétiquement et électriquement isolante et éventuellement la fine couche métallique d'accrochage, former le barreau magnétorésistif par dépôt d'un matériau magnétorésistif que l'on grave puis former des amenées de courant.

Dans une seconde variante, on forme le barreau sur le substrat, puis la couche magnétiquement et électriquement isolante et enfin le guide de flux.

De façon générale, les dépôts des couches peuvent se faire par pulvérisation cathodique, par évaporation sous vide, ou par épitaxie par jets moléculaires. Les gravures sont réalisées par usinage ionique ou par gravure chimique.

On va maintenant décrire l'invention plus en détail à l'aide des figures suivantes annexées à titre illustratif et non limitatif :

- la figure 1, déjà décrite, représente schématiquement un barreau magnétorésistif de section elliptique permettant l'illustration des champs démagnétisants ;
- la figure 2 représente schématiquement, en vue de dessus, un capteur magnétorésistif conforme à l'invention ;
- la figure 3 représente, partiellement et à échelle agrandie en vue de dessus, une première variante de réalisation du guide de flux,
- la figure 4 représente, en vue de dessus, le guide de flux de la figure 3, associé à un barreau magnétorésistif qui accentue la déviation des lignes de champ,

- la figure 5 représente, en vue de dessus, une seconde variante de réalisation du guide de flux,
- la figure 6 représente une coupe partielle agrandie du composant selon l'invention, et
- les figures 7A à 7E représentent, en coupe longitudinale, les phases successives d'un exemple de réalisation du composant de l'invention.

Comme on peut le voir sur la figure 2, le capteur selon l'invention comprend un guide de flux 1 comprenant une première et une seconde parties (2, 3) longitudinalement séparées par un entrefer 4 et un barreau magnétorésistif 5, disposé en regard et le long de l'entrefer 4.

La première et la seconde parties 2, 3 du guide sont pourvues en leurs bords 7, 8 de leur partie massive 2a, 3a, jouxtant l'entrefer 4 respectivement d'une première et d'une seconde séries de languettes 9, 10 séparées par des espacements 6a, 6b, les languettes 9 de la première partie 2 s'étendant dans les espacements 6a de la seconde partie 3, tandis que les languettes 10 de la seconde partie 3 s'étendent dans les espacements 6b de la première partie 2. Les extrémités 11, 12 du barreau magnétorésistif 5 sont reliées au moyen d'amenées de courant 13, 14 à des prises de contact 15, 16.

La forme du guide de flux 1 permet une déviation optimale des lignes du champ magnétique à détecter pour les concentrer dans le barreau 5 magnétorésistif.

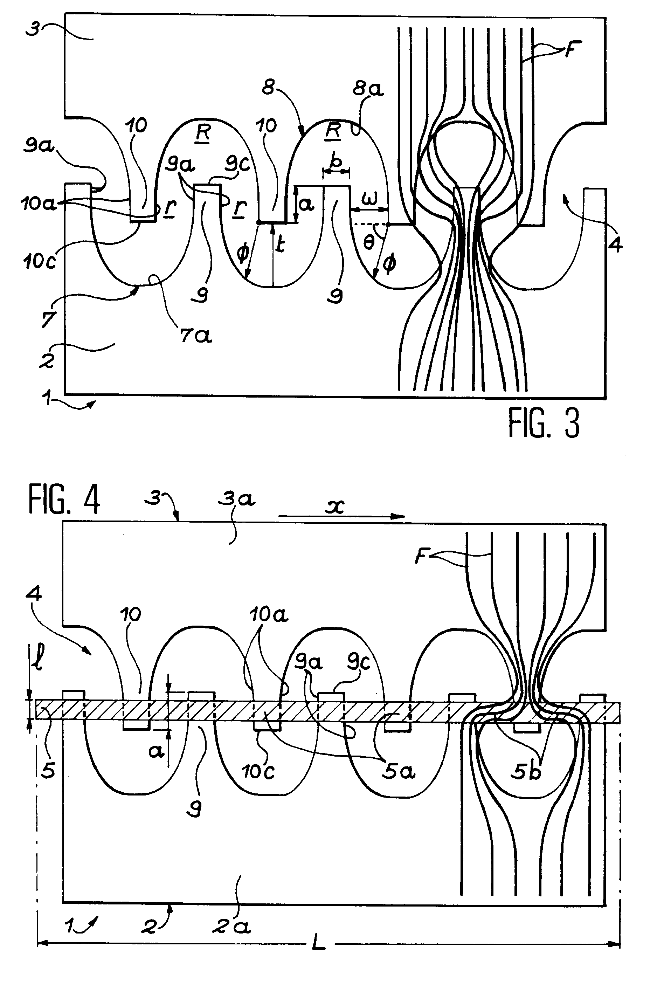

Ainsi que représenté à la figure 3, on voit que les lignes F de champ passent d'une languette 10 à une languette 9 en regard. Pour dévier de façon appréciable ces lignes F de champ, il est souhaitable que l'entrefer 4 soit de taille plus réduite dans les régions r situées entre les côtés latéraux 9a, 10a respectivement de deux languettes consécutives que dans les régions R entre les parties frontales 9c, 10c des languettes et le bord 7a, 8a de la partie du guide 1 leur faisant respectivement face.

Par ailleurs, les bords 7, 8 des parties 2, 3 du guide 1 présentent une courbure.

Cette courbure peut être de rayon constant ou, avantageusement, selon un rayon variant continûment avec une valeur minimale dans la direction parallèle aux languettes 9, 10.

Le guide 1 de la figure 3, présente des languettes à extrémité libre de forme rectangulaire dans le plan de la figure parallèle à la surface du barreau magnétorésistif, non représenté sur cette figure ; il est notamment défini par les paramètres suivants :

a : hauteur des côtés latéraux des languettes se faisant face ;

b : largeur des languettes 9, 10 en leur extrémité libre ;

t : distance séparant l'extrémité frontale libre 9c, 10c des languettes du bord 7a, 8a de la partie du guide 2, 3 respectivement opposée ;

w : la distance séparant les côtés latéraux 9a, 10a, de deux languettes 9, 10 consécutives ;

Φ : la distance séparant la partie frontale 9c, 10c des languettes du bord 7a, 8a de la partie du guide faisant face à la languette. Φ est une fonction d'un angle θ qui varie entre 0 et π/2.

On vérifie t ≥ Φ et Φ est une fonction croissante de θ avec Φ(O) = w et Φ(π/2)=t .

Comme représenté de manière agrandie à la figure 4, le barreau 5 magnétorésistif est disposé en regard de l'entrefer 4 et se superpose, du moins partiellement à l'extrémité des languettes 9, 10. Dans les régions 5a recouvrant les languettes 9, 10, le barreau 5 n'est pas polarisé par le champ magnétique à mesurer. Par contre, comme l'illustre la figure, dans les régions 5b ne recouvrant pas de languettes 9, 10 les lignes F de champ pénètrent dans le barreau parallèlement à sa longueur, ce qui a pour effet d'augmenter fortement sa sensibilité. Dans l'exemple de la figure 4, le barreau est disposé au-dessus du guide de flux, mais il pourrait très bien être situé sous le guide.

La largeur ℓ du barreau magnétorésistif 5 est choisie inférieure ou égale à "a" et la longueur L mesurée selon une direction x est au moins égale à celle du guide.

En comparant les lignes de champ F représentées à la figure 3 et celles de la figure 4, on constate que le barreau magnétorésistif 5 contribue largement à la déviation des lignes de champ, selon la longueur du barreau.

Dans le cas où une couche de matériau magnétiquement et électriquement isolant sépare le guide du barreau 5 et lorsque cette couche est épaisse et/ou si la perméabilité du barreau 5 est faible, les lignes de champ F sont moins bien captées par le barreau et sont aussi moins déviées.

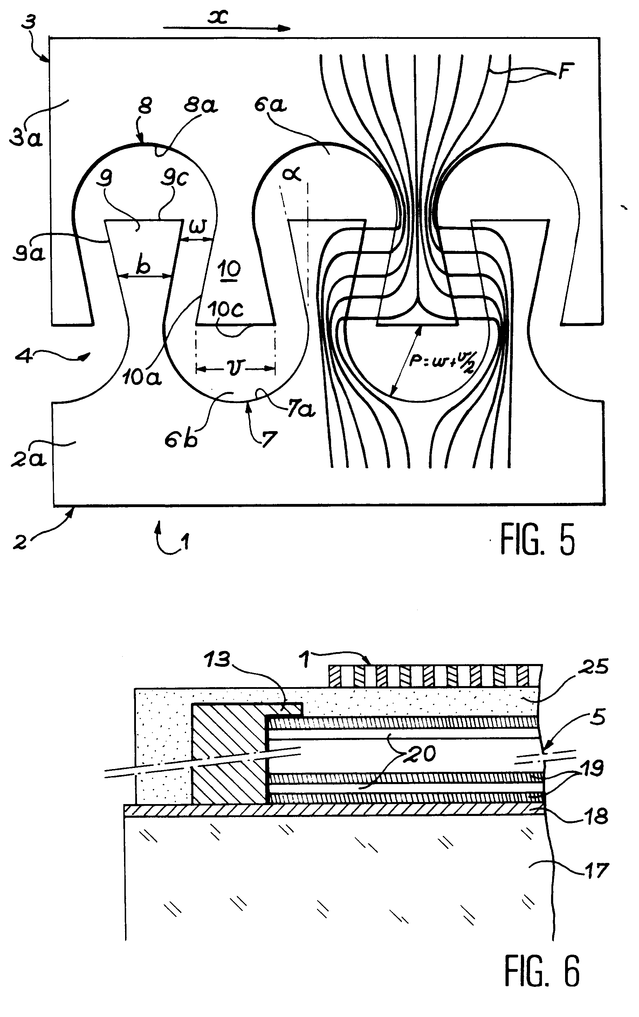

Pour remédier à cette situation, une autre forme de guide de flux telle que représentée par exemple sur la figure 5, permettant de dévier davantage les lignes de champ, est retenue.

Sur cette figure, l'extrémité libre des languettes 9, 10 est de forme trapézoïdale dans le plan de la figure, parallèle à la surface du barreau et les languettes sont reliées à une partie massive 2a, 3a du guide 1 par leur petite base.

Le paramètre b désigne la largeur à mi-hauteur des parties trapézoïdales des languettes, v la largeur de l'extrémité frontale 9c, 10c des languettes, constituée par la grande base du trapèze et w la distance entre les côtés latéraux 9a, 10a de deux languettes consécutives. Le bord 7, 8 des parties 2, 3 du guide 1 présente le long des espacements 6a, 6b une courbure en un arc de cercle de rayon

$$P = w + \frac{v}{2}$$

et centré au milieu de la partie frontale 9c, 10c des languettes 9, 10.

Les lignes de champ F, comme on le voit sur la figure, et même en l'absence de barreau magnétorésistif sont déviées jusqu'à atteindre une direction parallèle à x.

La déviation des lignes F de champ est ajustée notamment en agissant sur un paramètre α défini comme étant l'angle entre chaque côté latéral 9a, 10a, des languettes 9, 10 et la normale à x.

La figure 6 illustre une réalisation particulière du capteur et les différentes couches de matériau utilisés. Sur cette figure, l'épaisseur des couches est exagérée pour faciliter la compréhension.

Une fine couche métallique 18 de quelques dizaines de nanomètres, de fer ou de cuivre peut dans certains cas recouvrir un substrat 17 de verre, de silice, ou de Kapton par exemple.

Le barreau est formé sur la fine couche métallique 18, en une succession de couches magnétiques 19 en alliage de fer et de nickel, ou de fer de nickel et de cobalt, séparées par des couches non magnétiques 20 de cuivre ou d'argent. Une couche magnétiquement et électriquement isolante 25 (silice) sépare le barreau 5 du guide de flux 1.

Le matériau choisi pour servir de guide de flux est un matériau magnétique doux, par exemple un alliage à base de fer et de nickel ou bien une structure magnétique multicouche métallique.

L'amenée de courant 13 est connectée sur un côté latéral et sur le dessus du barreau, néanmoins, il est possible également de ne connecter les amenées de courant que sur le dessus du barreau.

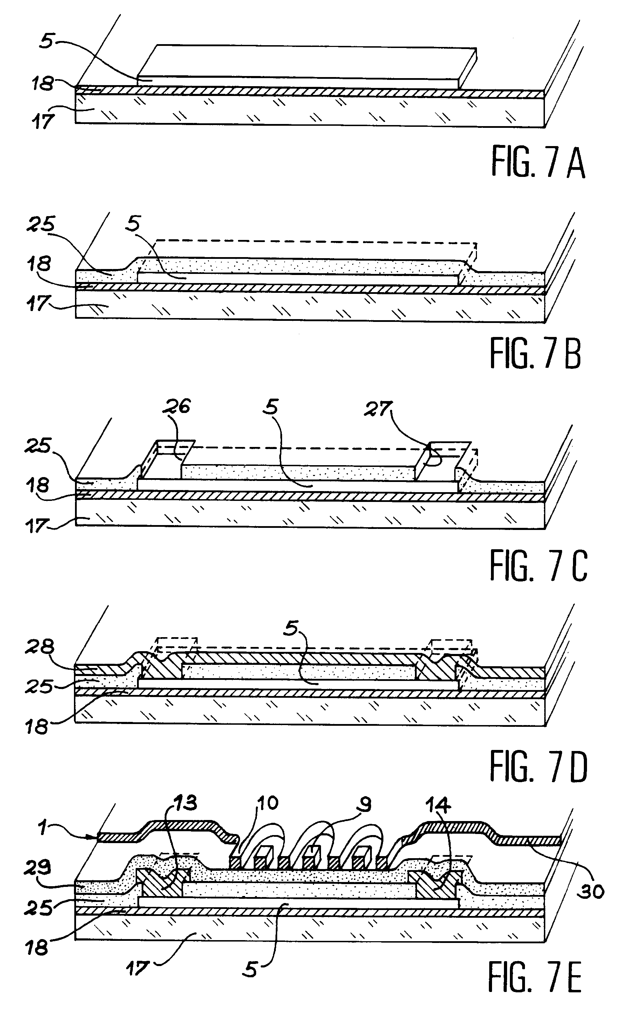

Les différentes opérations de réalisation de ce capteur ressortent des figures 7A à 7F.

Dans un premier temps (figure 7A), il est possible de déposer par pulvérisation cathodique, sur le substrat 17 la couche métallique 18, puis une structure magnétorésistive multicouche constituée des couches magnétiques et non magnétiques alternées.

Au moyen d'un masque adapté et de procédés de photolithogravure connus, on grave par usinage ionique la structure multicouche pour former le barreau 5.

On recouvre ensuite, telle que le montre la figure 7B, l'ensemble d'une première couche isolante de silice 25.

Des ouvertures 26, 27 sont pratiquées dans cette couche 25 aux extrémités du barreau 5 (figure 7C) et une couche conductrice 28 par exemple en tungstène est déposée en vue de prendre des contacts sur les extrémités du barreau (figure 7D).

La couche conductrice 28 est gravée à son tour, afin de former les amenées de courant 13, 14.

Une seconde couche isolante 29 est déposée sur l'ensemble avant de déposer une nouvelle couche magnétique 30. Cette couche magnétique douce est finalement gravée pour former le guide de flux 1 (figure 7E).

Pour des raisons de clarté, le nombre de languettes du guide de flux représenté à la figure 7E a été réduit.

En guise d'exemple, le guide de flux a une épaisseur de 0,5 μm.

Des prises de contact, non représentées, sont également réalisées sur les amenées de courant.

Selon une variante non représentée, le guide de flux est formé avant le barreau magnétorésistif, une couche électriquement et magnétiquement isolante séparant également le guide de flux du barreau magnétorésistif.

Le composant à effet magnétorésistif selon l'invention est particulièrement destiné à la réalisation d'une tête de lecture magnétique à lecture verticale ou horizontale.

Elle peut être associée à un enroulement électrique d'enregistrement de manière à remplir à la fois les fonctions de lecture et d'enregistrement.

## Revendications

1.  Capteur de champ magnétique à effet magnétorésistif comprenant un guide de flux magnétique (1) comportant une première et une seconde parties (2, 3) longitudinalement séparées par un entrefer (4) et un barreau magnétorésistif (5) disposé en regard et le long de l'entrefer (4), caractérisé en ce que la première et la seconde parties (2, 3) du guide sont pourvues en leurs bords (7, 8) jouxtant l'entrefer (4) respectivement d'une première et d'une seconde séries de languettes (9, 10) séparées par des espacements, les languettes (9) de la première partie (2) s'étendant dans les espacements de la seconde partie (3) et réciproquement, le barreau magnétorésistif (5) présentant de l'effet magnétorésistif quand le champ magnétique externe à mesurer a la même direction que la longueur du barreau.

2.  Capteur à effet magnétorésistif selon la revendication 1, caractérisé en ce que le barreau magnétorésistif (5) est superposé, au moins en partie, aux languettes (9, 10) de la première et de la seconde séries de languettes.

3.  Capteur à effet magnétorésistif selon la revendication 1 ou 2, caractérisé en ce que les languettes (9, 10) présentent des côtés latéraux (9a, 10a) et une partie frontale (9c, 10c), l'entrefer est de taille plus réduite dans des régions r situées entre les côtés latéraux (9a, 10a) respectivement de deux languettes consécutives de la première et de la deuxième séries que dans des régions R entre les parties frontales (9c, 10c) des languettes et le bord (7a, 8a) de la partie du guide leur faisant respectivement face.

**4.** Capteur à effet magnétorésistif selon l'une quelconque des revendications 1 à 3, caractérisé en ce que les languettes (9, 10) sont de forme trapézoïdale dans un plan parallèle à la surface du barreau (5) et reliées à une partie massive du guide (2a, 3a) par leur petite base.

**5.** Capteur à effet magnétorésistif selon l'une quelconque des revendications 1 à 3 caractérisé en ce que les languettes (9, 10) présentent une extrémité libre de forme rectangulaire dans un plan parallèle à la surface du barreau (5).

**6.** Capteur à effet magnétorésistif selon l'une quelconque des revendications précédentes, caractérisé en ce que les bords (7, 8) du guide présentent une courbure le long des espacements (6a, 6b) entre les languettes (9, 10).

**7.** Capteur à effet magnétorésistif selon la revendication 6, caractérisé en ce que la distance $\phi$ séparant la partie frontale (9c, 10c) des languettes (9, 10) du bord (7a, 8a) de la partie du guide faisant respectivement face aux languettes (9, 10) varie continûment avec une valeur maximale dans la direction parallèle aux languettes (9, 10).

**8.** Capteur à effet magnétorésistif selon l'une quelconque des revendications précédentes, caractérisé en ce que le barreau et/ou le guide de flux sont réalisés en couche mince.

**9.** Capteur à effet magnétorésistif selon la revendication 8, caractérisé en ce que le barreau magnétorésistif est formé d'un empilement de couches en matériau magnétique (19) séparées par des couches de matériau non magnétique (20).

**10.** Capteur à effet magnétorésistif selon la revendication 8, caractérisé en ce que le matériau magnétique est un alliage de fer et de nickel ou de fer, de nickel et de cobalt.

**11.** Capteur à effet magnétorésistif selon la revendication 9 ou 10, caractérisé en ce que le matériau non magnétique est choisi parmi le cuivre et l'argent.

**12.** Capteur à effet magnétorésistif selon l'une des revendications précédentes, caractérisé en ce que le guide de flux est réalisé à partir d'une structure magnétique multicouche métallique.

**13.** Capteur à effet magnétorésistif selon l'une des revendications 8 à 12, caractérisé en ce qu'une couche isolante électriquement et magnétiquement est prévue pour isoler le guide de flux du barreau magnétorésistif.

**14.** Guide de flux magnétique comportant une première et une seconde parties (2, 3) longitudinalement séparées par un entrefer (4), la première et la seconde parties (2, 3) du guide sont pourvues en leurs bords (7, 8) jouxtant l'entrefer (4) respectivement d'une première et d'une seconde séries (9, 10) de languettes séparées par des espacements, les languettes (9) de la première partie (2) s'étendant dans les espacements de la seconde partie (3) et réciproquement.

**15.** Guide de flux magnétique selon la revendication 14, caractérisé en ce que les languettes (9, 10) présentant des côtés latéraux (9a, 10a) et une partie frontale (9c, 10c), l'entrefer étant de taille plus réduite dans des régions r situées entre les côtés latéraux (9a, 10a) respectivement de deux languettes consécutives de la première et de la deuxième séries que dans des régions R entre les parties frontales (9c, 10c) des languettes et le bord (7a, 8a) de la partie du guide leur faisant respectivement face.

**Claims**

**1.** Magnetoresistive magnetic field transducer incorporating a magnetic flux guide (1) having a first and a second parts (2, 3) longitudinally separated by a head gap (4) and a magnetoresistive bar (5) placed facing and along the head gap (4), characterized in that the first and second parts (2, 3) of the guide are provided on their edges (7, 8) contiguous with the head gap (4) respectively with a first and a second series of tongues (9, 10) separated by spaces, the tongues (9) of the first part (-2) extending into the spaces of the second part (3) and vice versa, the magnetoresistive bar (5) having a magnetoresistive effect when the external magnetic field to be measured has the same direction as the length of the bar.

**2.** Magnetoresistive transducer according to claim 1, characterized in that the magnetoresistive bar (5) is at least partly superimposed on the tongues (9, 10) of the first and second series of tongues.

**3.** Magnetoresistive transducer according to claim 1 or 2, characterized in that the tongues (9, 10) have lateral sides (9a, 10a) and a front portion (9c, 10c), the head gap having a smaller size in the regions r between the lateral sides (9a, 10a) respectively of two consecutive tongues of the first and second series than in the regions R between the front portions (9c, 10c) of the tongues and the edge (7a, 8a) of that portion of the guide respectively facing the same.

**4.** Magnetoresistive transducer according to any one of the claims 1 to 3, characterized in that the tongues (9, 10) are trapezoidal in a plane parallel to the surface of the bar (5) and connected to a solid part of the guide (2a, 3a) by their small base.

5. Magnetoresistive transducer according to any one of the claims 1 to 3, characterized in that the tongues (9, 10) have a free rectangular end in a plane parallel to the surface of the bar (5).

6. Magnetoresistive transducer according to any one of the preceding claims, characterized in that the edges (7, 8) of the guide have a curvature along the spaces (6a, 6b) between the tongues (9, 10).

7. Magnetoresistive transducer according to claim 6, characterized in that the distance $\phi$ separating the front portion (9c, 10c) of the tongues (9, 10) from the edge (7a, 8a) of that portion of the guide respectively facing the tongues (9, 10) varies continuously with a maximum value in the direction parallel to the tongues (9, 10).

8. Magnetoresistive transducer according to any one of the preceding claims, characterized in that the bar and/or flux guide are produced in thin film form.

9. Magnetoresistive transducer according to claim 8, characterized in that the magnetoresistive bar is formed from a stack of magnetic material layers (19) separated by non-magnetic material layers (20).

10. Magnetoresistive transducer according to claim 8, characterized in that the magnetic material is an iron and nickel alloy or an iron, nickel and cobalt alloy.

11. Magnetoresistive transducer according to claim 9 or 10, characterized in that the non-magnetic material is chosen from among copper and silver.

12. Magnetoresistive transducer according to any one of the preceding claims, characterized in that the flux guide is formed from a metallic multilayer magnetic structure.

13. Magnetoresistive transducer according to one of the claims 8 to 12, characterized in that an electrically and magnetically insulating layer is provided for insulating the flux guide from the magnetoresistive bar.

14. Magnetic flux guide, comprising a first and a second portions (2, 3) longitudinally separated by a head gap (4), the first and second portions (2, 3) of the guide being provided on their edges (7, 8) contiguous with the head gap (4) respectively with a first and a second series (9, 10) of tongues separated by spaces, the tongues (9) of the first portion (2) extending into the spaces of the second portions (3) and vice versa.

15. Magnetic flux guide according to claim 14, characterized in that the tongues (9, 10) have lateral sides (9a, 10a) and front portion (9c, 10c), the head gap having a smaller size in the regions r between the lateral sides (9a, 10a) respectively of two consecutive tongues of the first and second series than in the regions R between the front portions (9c, 10c) of the tongues and the edge (7a, 8a) of that portion of the guide respectively facing them.

**Patentansprüche**

1. Magnetfeld-Sensor mit magnetoresistivem Effekt, der einen Magnetflussleiter (1) enthält, welcher einen ersten und einen zweiten Teil (2, 3) umfasst, die longitudinal durch einen Luftspalt (4) und einen magnetoresistiven Stab (5) getrennt sind, der längs des Luftspalts (4) diesem gegenübersteht,
   **dadurch gekennzeichnet,**
   dass der erste und der zweite Teil (2, 3) des Leiters an ihren den Luftspalt (4) abgrenzenden Rändern (7, 8) jeweils eine erste und eine zweite Serie von Zungen (9, 10) aufweisen, die durch Zwischenräume getrennt sind, wobei die Zungen (9) des ersten Teils (2) sich in die Zwischenräume des zweiten Teils (3) erstrecken und umgekehrt, und der magnetoresistive Stab (5) einen magnetoresistiven Effekt aufweist, wenn das zu messende äußere Magnetfeld dieselbe Richtung wie die Länge des Stabs hat.

2. Sensor mit magnetoresistivem Effekt nach Anspruch 1, dadurch gekennzeichnet, dass der magnetoresistive Stab (5) wenigstens teilweise die Zungen (9, 10) der ersten und der zweiten Zungenserie überdeckt.

3. Sensor mit magnetoresistivem Effekt nach Anspruch 1 oder 2, dadurch gekennzeichnet, dass die Zungen (9, 10) seitliche Ränder (9a, 10a) und einen vorderen Teil (9c, 10c) aufweisen und der Luftspalt in Bereichen r, die sich zwischen den seitlichen Rändem (9a, 10a) von jeweils zwei aufeinanderfolgenden Zungen der ersten und der zweiten Serie befinden, kleiner ist als in Bereichen R, die sich zwischen den vorderen Teilen (9c, 10c) der Zungen und dem Rand (7a, 8a) des Teils des Leiters befinden, der ihnen jeweils gegenübersteht.

4. Sensor mit magnetoresistivem Effekt nach einem der Ansprüche 1 bis 3, dadurch gekennzeichnet, dass die Zungen (9, 10) in einer zu der Oberfläche des -Stabs (5) parallelen Ebene trapezförmig sind und durch ihre kleine Basis mit einem massiven Teil des Leiters (2a, 3a) verbunden sind.

**5.** Sensor mit magnetoresistivem Effekt nach einem der Ansprüche 1 bis 3, dadurch gekennzeichnet, dass die Zungen (9, 10) in einer zu der Oberfläche des Stabs (5) parallelen Ebene ein rechteckförmiges freies Ende aufweisen.

**6.** Sensor nach einem der vorangehenden Ansprüche, dadurch gekennzeichnet, dass die Ränder (7, 8) des Leiters längs der Zwischenräume (6a, 6b) zwischen den Zungen (9, 10) eine Krümmung aufweisen.

**7.** Sensor mit magnetoresistivem Effekt nach Anspruch 6, dadurch gekennzeichnet, dass der Abstand φ, der den vorderen Teil (9c, 10c) der Zungen (9, 10) vom Rand (7a, 8a) des Teils des Leiters trennt, der jeweils den Zungen (9, 10) gegenübersteht, sich kontinuierlich verändert, mit einem Höchstwert in der zu den Zungen (9, 10) parallelen Richtung.

**8.** Sensor nach einem der vorangehenden Ansprüche, dadurch gekennzeichnet, dass der Stab und/oder der Flussleiter aus Dünnschichten hergestellt sind.

**9.** Sensor mit magnetoresistivem Effekt nach Anspruch 8, dadurch gekennzeichnet, dass der magnetoresistive Stab durch einen Stapel von Schichten (19) aus magnetischem Material gebildet wird, die durch Schichten (20) aus unmagnetischem Material getrennt sind.

**10.** Sensor mit magnetoresistivem Effekt nach Anspruch 8, dadurch gekennzeichnet, dass das magnetische Material eine Legierung aus Eisen und Nickel oder aus Eisen, Nickel und Kobalt ist.

**11.** Sensor mit magnetoresistivem Effekt nach Anspruch 9 oder 10, dadurch gekennzeichnet, dass das unmagnetische Material zwischen Kupfer und Silber gewählt wird.

**12.** Sensor mit magnetoresistivem Effekt nach einem der vorangehenden Ansprüche, dadurch gekennzeichnet, dass der Flussleiter durch eine metallische magnetische Mehrschichtstruktur gebildet wird.

**13.** Sensor mit magnetoresistivem Effekt nach einem der Ansprüche 8 bis 12, dadurch gekennzeichnet, dass eine elektrisch und magnetisch isolierende Schicht vorgesehen ist, um den Flussleiter des magnetoresitiven Stabs zu isolieren.

**14.** Magnetflussleiter mit einem ersten und einem zweiten Teil (2, 3), longitudinal durch einen Luftspalt (4) getrennt, wobei der erste und der zweite Teil (2, 3) des Leiters an ihren den Luftspalt (4) abgrenzenden Rändern (7, 8) jeweils mit einer ersten und einer zweiten Serie (9, 10) von durch Zwischenräume getrennten Zungen versehen sind und die Zungen (9) des ersten Teils (2) sich in die Zwischenräume des zweiten Teils (3) erstrecken und umgekehrt.

**15.** Magnetflussleiter nach Anspruch 16, dadurch gekennzeichnet, dass die Zungen (9, 10) seitliche Ränder (9a, 10a) und einen vorderen Teil (9c, 10c) aufweisen, und der Luftspalt in Bereichen r, die sich zwischen den seitlichen Rändern (9a, 10a) von jeweils zwei aufeinanderfolgenden Zungen der ersten und der zweiten Serie befinden, kleiner ist als in Bereichen R, die sich zwischen den vorderen Teilen (9c, 10c) der Zungen und dem Rand (7a, 8a) des Teils des Leiters befinden, der ihnen jeweils gegenübersteht.

EP 0 642 030 B1

FIG. 1

FIG. 2

10

FIG. 3

FIG. 4

FIG. 5

FIG. 6

FIG. 7 A

FIG. 7 B

FIG. 7 C

FIG. 7 D

FIG. 7 E